# EUROPEAN PATENT APPLICATION

(11) **EP 3 029 509 A1**
(43) Date of publication of application: **08.06.2016**
(21) Application number: 13890590.6
(22) Date of filing: 12.12.2013
(51) Int. Cl.: G02B 26/10, G02B 26/08

(54) **MIRROR DEVICE**

(30) Priority: 01.08.2013 JP 2013160589
(71) Applicant: Hamamatsu Photonics K.K., Hamamatsu-shi, Shizuoka 435-8558 (JP)
(72) Inventor: TAKIMOTO Sadaharu, Hamamatsu-shi Shizuoka 435-8558 (JP); KIMOTO Masakuni, Hamamatsu-shi Shizuoka 435-8558 (JP); ADACHI Norihide, Hamamatsu-shi Shizuoka 435-8558 (JP)
(74) Representative: Hoffmann Eitle
(86) International application number: PCT/JP2013/083360
(87) International publication number: WO 2015/015664

(57) **Abstract**

A mirror device 1 includes a mirror structure 10 including a support portion 11, a first movable portion 12 and a second movable portion 13 coupled to the support portion 11 so as to be swingable, and, a mirror 16, a first coil 17, and a second coil 18 disposed on the movable portions; a first magnetic portion 21 and a second magnetic portion 22 disposed on a same side as a back surface 10b of the mirror structure 10 to be opposed to the mirror structure 10, and having a magnetic pole 21a of a first polarity and a magnetic pole 22b of a second polarity, respectively; and a cap structure 30 disposed on a same side as a surface 10a of the mirror structure 10. The cap structure 30 includes a first region 31 having a magnetic pole 31a of the first polarity located to be opposed to the magnetic pole 21a; a second region 32 having a magnetic pole 32b of the second polarity located to be opposed to the magnetic pole 22b; and an unmagnetized third region 33 located between the first region 31 and the second region 32.

## Description

### Technical Field

The present invention relates to a mirror device.

### Background Art

Known mirror devices capable of changing an optical path of reflected light include a fixed frame, a movable frame coupled to the fixed frame through beams, and a mirror disposed on the movable frame (e.g., cf. Patent Literature 1). The mirror device described in Patent Literature 1 includes a plurality of permanent magnets provided above and below the fixed frame, and a coil comprising a conductor and provided on the movable frame. In the mirror device described in Patent Literature 1, an electric current is supplied to the coil, whereupon a force according to a magnetic field formed by the permanent magnets and the electric current flowing through the coil acts on the coil so that the movable frame is swung by the torque acting on the coil, so as to swing the mirror.

### Citation List

### Patent Literature

Patent Literature 1: U.S. Pat. No. 8,237,522

### Summary of Invention

### Technical Problem

In the foregoing mirror device, conceivable measures for increasing a swing angle of the mirror include increase in the number of turns of the coil, increase of the electric current supplied to the coil, and enhancement of the magnetic field in the vicinity of the coil. However, the increase in the number of turns of the coil will lead to increase in area occupied by the coil, which makes downsizing of the mirror difficult. The increase of the current entails possible disconnection of the coil due to heat generated thereby, and as well as an increase power consumption, which is unfavorable. It is thus preferred to enhance the magnetic field in the vicinity of the coil.

However, the mirror device described in Patent Literature 1 requires the individual magnets to be positioned relative to the coil, which makes it difficult to implement precise positioning of the magnets relative to the coil. It is thus difficult to positively concentrate the magnetic field in the vicinity of the coil.

It is therefore an object of the present invention to provide a mirror device capable of positively concentrating a magnetic field in the vicinity of the coil.

### Solution to Problem

A mirror device according to one aspect of the present invention includes a mirror structure including a support portion, a movable portion coupled to the support portion so as to be swingable, and, a mirror and a coil disposed on the movable portion; a first magnetic portion having a magnetic pole of a first polarity and disposed on a back side of the mirror structure with respect to a surface where the mirror of the mirror structure is disposed, so that the magnetic pole of the first polarity is opposed to the mirror structure; a second magnetic portion having a magnetic pole of a second polarity different from the first polarity and disposed on the back side of the mirror structure so that the magnetic pole of the second polarity is opposed to the mirror structure; and a cap structure disposed on a same side as the surface where the mirror of the mirror structure is disposed. The cap structure includes a first region having a magnetic pole of the first polarity located to be opposed to the magnetic pole of the first polarity of the first magnetic portion; a second region having a magnetic pole of the second polarity located to be opposed to the magnetic pole of the second polarity of the second magnetic portion; and an unmagnetized third region located between the first region and the second region.

In the mirror device according to the one aspect of the present invention, the magnetic pole of the first polarity of the first magnetic portion is opposed to the magnetic pole of the first polarity of the first region of the cap structure, and the magnetic pole of the second polarity of the second magnetic portion is opposed to the magnetic pole of the second polarity of the second region of the cap structure. For this reason, a strong magnetic field is formed in the vicinity of the coil by the first magnetic portion, the second magnetic portion, and, the first and second regions of the cap structure. The magnetic field formed by the first region and the second region can be concentrated in the vicinity of the coil by adjusting the size of the unmagnetized third region located between the first region and the second region. Furthermore, this magnetic field is confined in the vicinity of the coil by the cap structure including the third region. This further enhances the magnetic field in the vicinity of the coil.

Here, the first region and the second region forming the magnetic field in the vicinity of the coil are integrally formed as the cap structure. For this reason, it becomes easy to highly accurately position the first region and the second region relative to the coil. Therefore, the mirror device according to the present invention can positively concentrate the magnetic field in the vicinity of the coil.

The mirror device may further include a housing including an opening portion and housing the mirror structure, the first magnetic portion, and the second magnetic portion, and the cap structure may be disposed to cover the opening portion. In this case, the first magnetic portion and the second magnetic are housed in the housing to be positioned relative to the mirror structure. At the same time, the opening portion of the housing is covered by the cap structure, whereby the magnetic field is confined in the vicinity of the coil. For this reason, the magnetic field formed by the first magnetic portion and the second magnetic portion can be more positively concentrated in the vicinity of the coil.

A through hole may be formed at a position corresponding to the mirror in the third region and the through hole may be defined by a tapered inner surface with its diameter increasing from a same side as a surface of the cap structure opposed to the mirror structure, to a back side of the cap structure. In order to enhance the magnetic field in the vicinity of the coil of the mirror structure, it is necessary to increase the thickness of the cap structure and locate the cap structure at a position close to the mirror structure. However, when the through hole is defined by the tapered inner surface as described above, light being incident on the mirror through the through hole and light passing through the through hole after reflected by the mirror become less likely to interfere with the peripheral portion of the through hole. For this reason, angles of input/output of light to and from the mirror can be made larger.

The mirror device may further include a third magnetic portion disposed between the first magnetic portion and the second magnetic portion, and the first magnetic portion, the third magnetic portion, and the second magnetic portion may constitute a Halbach array. In this case, the magnetic field formed in the vicinity of the coil can be more enhanced by the first magnetic portion, the third magnetic portion, and the second magnetic portion constituting the Halbach array.

The cap structure may comprise a single member and include the first region and the second region obtained by magnetizing respective corresponding regions in the single member. In this case, the single member including the first region and the second region is positioned relative to the mirror structure, whereby both of the first region and the second region are positively positioned at desired positions with respect to the mirror structure. For this reason, the magnetic field can be more positively concentrated in the vicinity of the coil.

The first magnetic portion and the second magnetic portion may be configured by magnetizing respective corresponding regions in a single member. In this case, the single member constituting the first magnetic portion and the second magnetic portion is positioned relative to the mirror structure, whereby both of the first magnetic portion and the second magnetic portion are positively positioned at desired positions with respect to the mirror structure. For this reason, the magnetic field can be more positively concentrated in the vicinity of the coil.

The coil may have a substantially rectangular shape, and the first magnetic portion and the second magnetic portion may be arranged in a direction intersecting with extending directions of respective sides of the coil. In this case, a direction of the magnetic field formed by the first magnetic portion and the second magnetic portion is aligned with the direction intersecting with the extending directions of the respective sides of the coil. Therefore, when an electric current is supplied to the coil, a force acts on all the sides of the coil. For this reason, the mirror can be efficiently swung.

The coil may be disposed on a same side as the first magnetic portion and the second magnetic portion with respect to the mirror and disposed to overlap the mirror when viewed from a direction normal to the mirror. In this case, for forming the magnetic field at the position where the coil is disposed, it is necessary to locate the first region and the second region forming the magnetic field nearer to each other and it becomes difficult to implement the positioning of the first region and the second region. In the present invention, however, the first region and the second region are disposed as regions of the cap structure, which makes the positioning of the first region and the second region easier. Therefore, the aforementioned configuration suitably exhibits the effect of the present invention that the magnetic field can be concentrated in the vicinity of the coil.

### Advantageous Effects of Invention

The present invention has provided the mirror device capable of positively concentrating the magnetic field in the vicinity of the coil.

### Brief Description of Drawings

Fig. 1 is a perspective view of a mirror device according to one embodiment of the present invention.
Fig. 2 is a cross-sectional view along the line II-II in Fig. 1.
Fig. 3 is an exploded perspective view of the mirror device.
Fig. 4 is a plan view of a mirror structure.
Fig. 5 is a drawing showing position of coils in the mirror structure.
Fig. 6 is a drawing schematically showing magnetic fields in the vicinity of the coils.
Fig. 7 is a graph showing difference of swing angle depending upon the presence/absence of a cap structure.
Fig. 8 is a drawing showing another example of position of coils in the mirror structure.

### Description of Embodiments

Embodiments of the present invention will be described below in detail with reference to the accompanying drawings. In the description the same elements or elements with the same functionality will be denoted by the same reference signs, without redundant description.

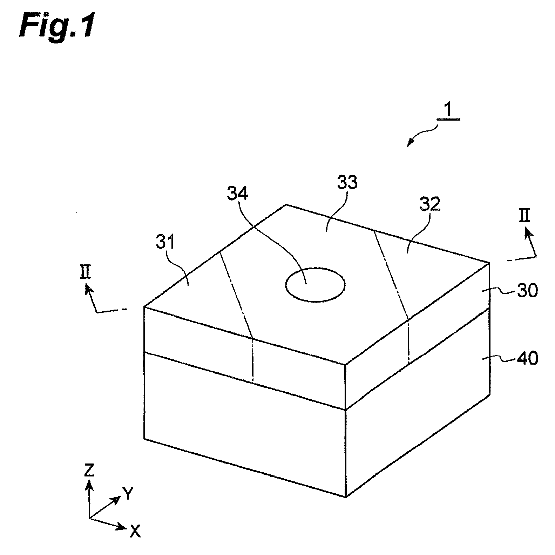

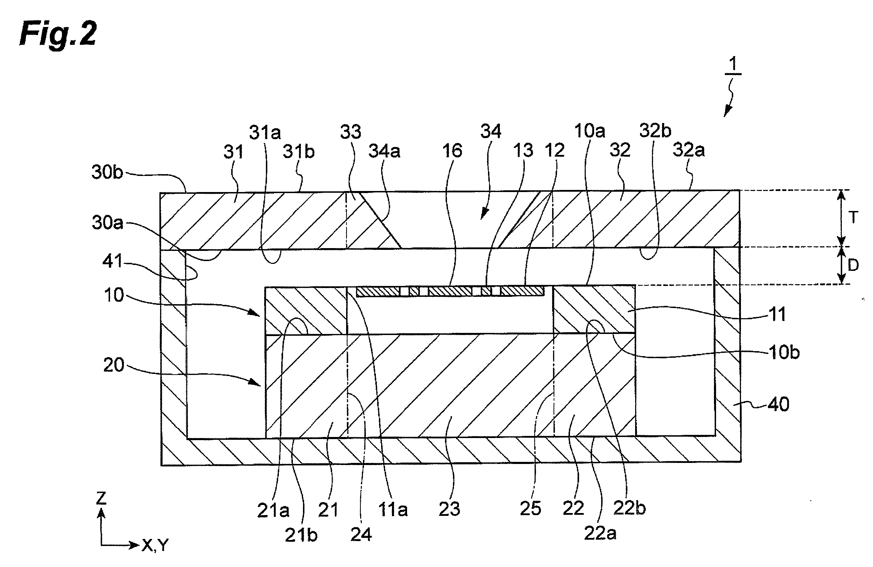

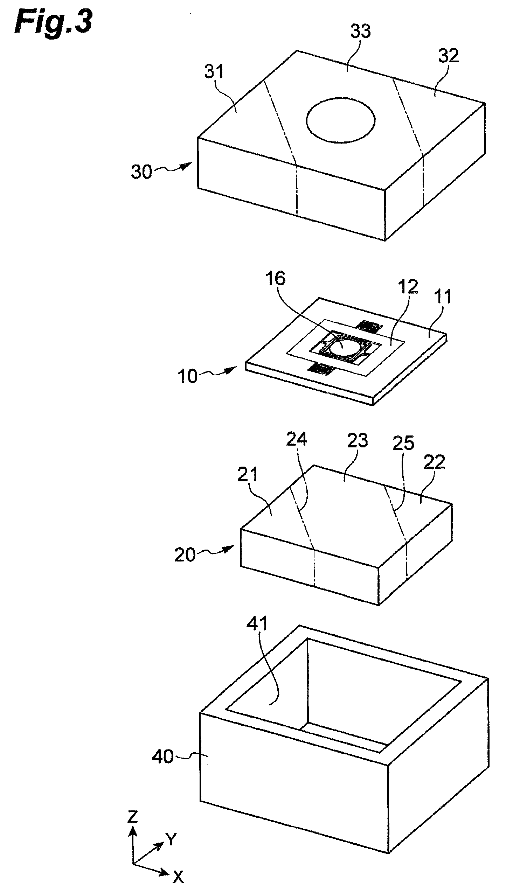

A configuration of a mirror device 1 according to the present embodiment will be described with reference to Figs. 1 to 3. Fig. 1 is a perspective view of the mirror device 1. Fig. 2 is a cross-sectional view along the line II-II in Fig. 1. Fig. 3 is an exploded perspective view of the mirror device 1. For convenience's sake of description, each drawing is provided with X-axis, Y-axis, and Z-axis.

As shown in Figs. 1 to 3, the mirror device 1 includes a mirror structure 10, a lower magnetic body 20, a cap structure 30, and a housing 40. The housing 40 has a substantially rectangular parallelepiped shape and houses the mirror structure 10 and lower magnetic body 20. The lower magnetic body 20 is disposed on a bottom surface of an opening portion 41 provided inside the housing 40. The mirror structure 10 is disposed above the lower magnetic body 20 (on a side in the positive direction of the Z-axis). The cap structure 30 is disposed to cover the opening portion 41 of the housing 40.

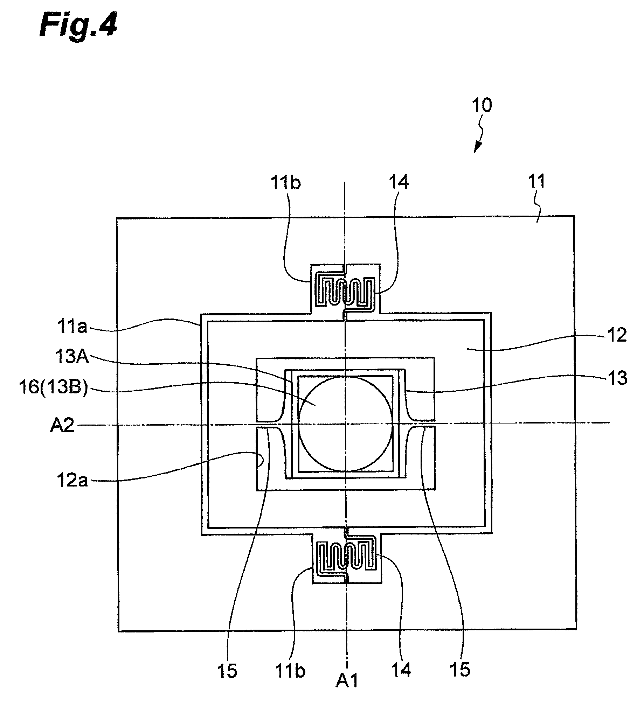

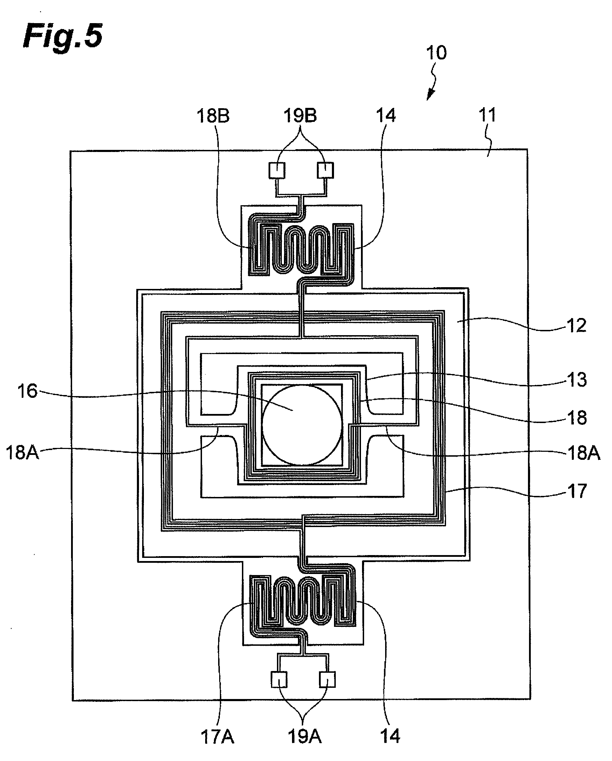

A configuration of the mirror structure 10 will be described in detail with reference to Figs. 4 and 5. Fig. 4 is a plan view of the mirror structure 10. Fig. 5 is a drawing showing position of a first coil 17 and a second coil 18 in the mirror structure 10. The mirror structure 10 includes a support portion 11, a first movable portion 12 (movable portion) coupled to the support portion 11, a second movable portion 13 (movable portion) coupled to the first movable portion 12, a mirror 16 disposed on the second movable portion 13, the first coil 17 (coil) disposed on the first movable portion 12, and the second coil 18 (coil) disposed on the second movable portion 13.

The support portion 11 is a frame body of a rectangular shape when viewed from the Z-axis direction. The support portion 11 is provided with a rectangular opening 11a. A pair of recesses 11b, 11b of a substantially rectangular shape for housing first beams are provided on two sides extending in the X-axis direction, in the outer edge of the opening 11 a. The first movable portion 12 is a member of a thin plate shape, which is disposed in the opening 11 a of the support portion 11. The first movable portion 12 is coupled to the support potion 11 by a pair of first beams 14, 14. The pair of first beams 14, 14 are located on a straight line A1 parallel to the Y-axis and provided on both sides of the first movable portion 12. The first movable portion 12 has a rectangular opening 12a. The first movable portion 12 is swingable around the straight line A1, relative to the support portion 11. Namely, the first movable portion 12 is rotatable back and forth around the straight line A1, relative to the support portion 11.

The second movable portion 13 comprises a frame 13A of a substantially square shape and a mirror arrangement portion 13B of a disc shape fixed to the inside of the frame 13A. Two sides parallel to each other out of the four sides of the frame 13A extend in the X-axis direction. The remaining two sides of the frame 13A extend in the Y-axis direction. An outer peripheral surface of the mirror arrangement portion 13B is in contact with inner peripheral surfaces of the four respective sides of the frame 13A. The second movable portion 13 is coupled to the first movable portion 12 by a pair of second beams 15, 15. The pair of second beams 15, 15 are located on a straight line A2 parallel to the X-axis and are provided on both sides of the second movable portion 13. The second movable portion 13 is swingable around the straight line A2, relative to the first movable portion 12. Namely, the second movable portion 13 is rotatable back and forth around the straight line A2, relative to the first movable portion 12.

The first beam 14 is of a meandering shape. It is noted, however, that the shape of the first beam 14 is not limited only to the meandering shape but the first beam 14 may also be a linearly extending one in the Y-axis direction.

The second beam 15 extends linearly in the X-axis direction. One end of the second beam 15 is connected to an inner peripheral surface of the opening 12a of the first movable portion 12. The other end of the second beam 15 is connected to an outer peripheral surface of the second movable portion 13. The other end side of the second beam 15 gradually increases its width toward the second movable portion 13 side. It is noted, however, that the shape of the second beam 15 is not limited only to the linear shape but may also be, for example, a meandering shape.

The mirror 16 is disposed on a face opposed to the cap structure 30, on the mirror arrangement portion 13B of the second movable portion 13. The mirror 16 is a light reflecting film comprising a metal thin film.

As shown in Fig. 5, the first coil 17 is disposed on the first movable portion 12. The first coil 17 has a substantially rectangular shape consisting of sides parallel to the X-axis and sides parallel to the Y-axis. In the present specification, the rectangular shape embraces a square. The first coil 17 can be constructed, for example, by forming a spiral groove in a surface on a side where the first movable portion 12 is opposed to the cap structure 30 and disposing a metal material in this groove. The first coil 17 is electrically connected to a pair of pads 19A, 19A on the support portion 11 by wiring 17A disposed on one first beam 14. Therefore, when an electric current is supplied to between the pair of pads 19A, 19A, the electric current is supplied to the first coil 17.

The second coil 18 is disposed on the frame 13A of the second movable portion 13. The second coil 18 has a substantially rectangular shape consisting of sides parallel to the X-axis and sides parallel to the Y-axis. The second coil 18 can be constructed, for example, by forming a spiral groove in a surface on a side where the frame 13A is opposed to the cap structure 30 and disposing a metal material in this groove. The second coil 18 is led out onto the first movable portion 12 by wiring 18A disposed on the second beams 15 and is electrically connected to a pair of pads 19B, 19B on the support portion 11 by wiring 18B arranged on the first beam 14. Therefore, when an electric current is supplied to between the pair of pads 19B, 19B, the electric current is supplied to the second coil 18.

The numbers of turns of the first coil 17 and the second coil 18 may be determined as occasion may demand. An increase in the numbers of turns of the first coil 17 and the second coil 18 will enhance a force generated in the first coil 17 and the second coil 18 with supply of the electric current to the first coil 17 and the second coil 18, so as to increase the swing angle of the mirror 16 in accordance therewith.

The mirror structure 10 having the above-described configuration is integrally formed, for example, by processing a semiconductor substrate of silicon or the like by a process of anisotropic etching or the like to form the first movable portion 12, the second movable portion 13, the first beams 14, and the second beams 15.

The description will be continued again referring to Figs. 1 to 3. The lower magnetic body 20 is a single member having a rectangular parallelepiped shape. Three sides orthogonal to each other in the lower magnetic body 20 extend in the X-axis direction, in the Y-axis direction, and in the Z-axis direction, respectively. The lower magnetic body 20 includes a first magnetic portion 21, a second magnetic portion 22, and a third magnetic portion 23. The first magnetic portion 21 and second magnetic portion 22 are arranged in a direction intersecting with the extending directions of the respective sides of the first coil 17 and the second coil 18 (i.e., the X-axis direction and the Y-axis direction). More specifically, the first magnetic portion 21 and the second magnetic portion 22 are disposed on one end side and on the other end side, respectively, in a direction of a diagonal of a bottom surface of the lower magnetic body 20, in the lower magnetic body 20. The third magnetic portion 23 is disposed between the first magnetic portion 21 and the second magnetic portion 22. A boundary surface 24 between the first magnetic portion 21 and the third magnetic portion 23 and a boundary surface 25 between the third magnetic portion 23 and the second magnetic portion 22 are planes being parallel to the Z-axis and intersecting with both of the X-axis and the Y-axis. The boundary surface 24 and the boundary surface 25 each make, for example, angles of 45° to the X-axis and to the Y-axis. When the first magnetic portion 21, second magnetic portion 22, and third magnetic portion 23 are disposed in this configuration, the first magnetic portion 21, second magnetic portion 22, and third magnetic portion 23 generate a magnetic field, for example, in a direction parallel to the diagonal direction of the bottom surface of the housing 40.

The first coil 17 and the second coil 18 are of the substantially rectangular shape consisting of the sides parallel to the X-axis and the sides parallel to the Y-axis. If the sides of the first coil 17 and the second coil 18 are parallel to the direction of the magnetic field, no force will act on the sides of the first coil 17 and second coil 18, even with flow of the electric current through the first coil 17 and second coil 18. For this reason, if the magnetic field generated by the lower magnetic body 20 is oriented in the direction parallel to the X-axis or in the direction parallel to the Y-axis, the lower magnetic body 20 will need to comprise separate magnetic bodies for generating magnetic fields in two directions, a magnetic field in a direction parallel to the X-axis and a magnetic field in a direction parallel to the Y-axis, in order to swing the second movable portion 13 in two-dimensional directions around the X-axis and around the Y-axis. In the present embodiment, however, the first magnetic portion 21, third magnetic portion 23, and second magnetic portion 22 of the lower magnetic body 20 generate the magnetic field in the direction being parallel to the Z-axis and intersecting with both of the X-axis and the Y-axis. Therefore, the present embodiment does not necessitate the separate magnetic bodies provided for generating the magnetic fields in the two directions.

It should be noted herein that even if the magnetic field generated by the lower magnetic body 20 is parallel to the X-axis or to the Y-axis, the second movable portion 13 can be swung in two-dimensional directions around the X-axis and around the Y-axis, without need for the lower magnetic body 20's generating the magnetic fields in the two directions, if the first coil 17 and second coil 18 are disposed so that the sides of the first coil 17 and second coil 18 extend in directions intersecting with both of the X-axis and the Y-axis.

The lower magnetic body 20 is disposed on a same side as a back surface 10b of the mirror structure 10, i.e., on a side in the negative direction of the Z-axis. The back surface 10b is the back side with respect to the surface where the mirror 16 of the mirror structure is disposed. Therefore, the first magnetic portion 21 and second magnetic portion 22 are disposed on the same side as the back surface 10b of the mirror structure 10.

The first magnetic portion 21 has a magnetic pole 21a of a first polarity and a magnetic pole 21b of a second polarity different from the first polarity. In the present embodiment, the first polarity is the polarity of the S pole and the second polarity is the polarity of the N pole. Conversely, the first polarity may be the polarity of the N pole and the second polarity may be the polarity of the S pole.

As shown in Fig. 2, the magnetic pole 21a is disposed to be opposed to the mirror structure 10. Namely, the magnetic pole 21a is disposed on a side in the positive direction of the Z-axis in the first magnetic portion 21. The magnetic pole 21b is disposed on an opposite side to the magnetic pole 21a, i.e., on a side in the negative direction of the Z-axis in the first magnetic portion 21.

The second magnetic portion 22 has a magnetic pole 22a of the first polarity and a magnetic pole 22b of the second polarity. The magnetic pole 22b is disposed to be opposed to the mirror structure 10. Namely, the magnetic pole 22b is disposed on a side in the positive direction of the Z-axis in the second magnetic portion 22. The magnetic pole 22a is disposed on an opposite side to the magnetic pole 22b, i.e., on a side in the negative direction of the Z-axis in the second magnetic portion 22.

The third magnetic portion 23 has a magnetic pole 23a of the first polarity and a magnetic pole 23b of the second polarity. The magnetic pole 23a is disposed on a side where it faces the first magnetic portion 21, in the third magnetic portion 23. The magnetic pole 23b is disposed on a side where it faces the second magnetic portion 22, in the third magnetic portion 23.

The first magnetic portion 21, third magnetic portion 23, and second magnetic portion 22 constitute a Halbach array. Specifically, in the first magnetic portion 21, the magnetic pole 21 a of the first polarity and the magnetic pole 21b of the second polarity of the first magnetic portion 21 are opposed in the normal direction to a surface 10a and the surface 10b of the mirror structure 10. In the third magnetic portion 23 adjoining the first magnetic portion 21, the magnetic pole 23a of the first polarity and the magnetic pole 23b of the second polarity of the third magnetic portion 23 are opposed in the direction parallel to the surface 10a and surface 10b of the mirror structure 10. In the second magnetic portion 22 adjoining the third magnetic portion 23 and located on an opposite side to the first magnetic portion 21 with respect to the third magnetic portion 23, the magnetic pole 22a of the first polarity and the magnetic pole 22b of the second polarity are opposed in the normal direction to the surface 10a and surface 10b of the mirror structure 10. As described above, in two adjacent portions out of the first magnetic portion 21, third magnetic portion 23, and second magnetic portion 22, the directions in each of which the two magnetic poles of each portion are opposed are directions normal to each other.

The cap structure 30 is of a platelike member of a rectangular shape when viewed from the Z-axis direction. The cap structure 30 is disposed on a same side as the surface where the mirror 16 of the mirror structure 10 is disposed, i.e., on the side in the positive direction of the Z-axis.

The cap structure 30 includes a first region 31, a second region 32, and a third region 33.

As shown in Fig. 2, the first region 31 has a magnetic pole 31a of the first polarity and a magnetic pole 31b of the second polarity. The magnetic pole 31a is disposed to be opposed to the magnetic pole 21 a of the first polarity of the first magnetic portion 21. Namely, the magnetic pole 31a is disposed on a side in the negative direction of the Z-axis in the first region 31. The magnetic pole 31b is disposed on an opposite side to the magnetic pole 31a in the first region 31, i.e., on a side in the positive direction of the Z-axis in the first region 31. A surface of the first region 31 on a side where it is opposed to the mirror structure 10 is parallel to the mirror structure 10.

The second region 32 has a magnetic pole 32a of the first polarity and a magnetic pole 32b of the second polarity. The magnetic pole 32b is disposed to be opposed to the magnetic pole 22b of the second polarity of the second magnetic portion 22. Namely, the magnetic pole 32b is disposed on a side in the negative direction of the Z-axis in the second region 32. The magnetic pole 32a is disposed on an opposite side to the magnetic pole 32b in the second region 32, i.e., on a side in the positive direction of the Z-axis in the second region 32. A surface of the second region 32 on a side where it is opposed to the mirror structure 10 is parallel to the mirror structure 10.

The third region 33 is located between the first region 31 and the second region 32. The third region 33 is not magnetized.

In the third region 33, a through hole 34 is formed at a position corresponding to the mirror 16, or, at a position where it overlaps the mirror 16 when viewed from the Z-axis direction. As shown in Fig., 2, the through hole 34 is defined by a tapered inner surface 34a with its diameter increasing from a same side as a surface 30a of the cap structure 30 opposed to the mirror structure 10, to a back surface 30b side.

The cap structure 30 can be constituted, for example, using a neodymium magnet or a samarium-cobalt magnet. In order to fully enhance a magnetic field formed by the first region 31 and the second region 32, a thickness T in the Z-axis direction of the cap structure 30 is preferably, for example, not less than 1 mm. Furthermore, a distance D in the Z-axis direction between the surface of the cap structure 30 on the side opposed to the mirror structure 10 and the mirror 16 is preferably smaller than the thickness T in the Z-axis direction of the cap structure 30.

The distance D will be further described. A positional accuracy in a height direction (Z-axis direction) and flatness of the mirror structure 10 and the magnetic body (e.g., the cap structure 30) located above the mirror structure 10 are very important parameters to control the magnetic field around the mirror structure 10. When a plurality of magnetic bodies are individually disposed as in the mirror device described in Patent Literature 1, it is difficult to maintain alignment in the height direction and flatness of the plurality of magnetic bodies. For this reason, there is a possibility of failing to obtain a desired magnetic field, because of deviation of a distance between the mirror structure 10 and the magnetic body. Particularly, when the aforementioned distance D between the cap structure 30 and the mirror 16 is smaller than the thickness T of the cap structure 30, a repulsion force between the mirror structure 10 and the magnetic body becomes large, which makes positioning of the magnetic body very difficult. Therefore, for accurately adjusting the distance D while maintaining a relation that the distance D is smaller than the thickness T, it is preferred that the first region 31 and the second region 32 be integrated as the cap structure 30, as in the present embodiment.

The distribution of the magnetic field formed by the first region 31 and the second region 32 can be modified by changing the size of the third region 33 located between the first region 31 and the second region 32. Therefore, the size of the third region 33 can be properly determined so as to concentrate the magnetic field formed by the first region 31 and the second region 32, in the vicinity of the first coil 17 and second coil 18. As described above, the magnetic pole 31a of the first polarity of the first region 31 is disposed to be opposed to the magnetic pole 21a of the first polarity of the first magnetic portion 21, and the magnetic pole 32b of the second polarity of the second region 32 is disposed to be opposed to the magnetic pole 22b of the second polarity of the second magnetic portion 22. Therefore, the first magnetic portion 21 and the second magnetic portion 22 generate the magnetic field, for example, in the direction parallel to the diagonal direction of the bottom surface of the housing 40 as the first magnetic portion 21, second magnetic portion 22, and third magnetic portion 23 do.

The cap structure 30 comprises a single member and has the first region 31 and the second region 32 obtained by magnetizing respective corresponding regions in this single member. In other words, the cap structure 30 is configured by magnetizing the first region 31 and the second region 32 in the single member. The magnetization of the first region 31 and the second region 32 can be implemented, for example, by arranging a coil around each of the respective portions of the first region 31 and the second region 32 and letting a predetermined electric current flow through this coil to generate a magnetic field.

The housing 40 is of a substantially rectangular parallelepiped shape and includes the opening portion 41. The housing 40 houses the mirror structure 10 and the lower magnetic body 20 in the opening portion 41. Namely, the housing 40 houses the mirror structure 10, the first magnetic portion 21, and the second magnetic portion 22.

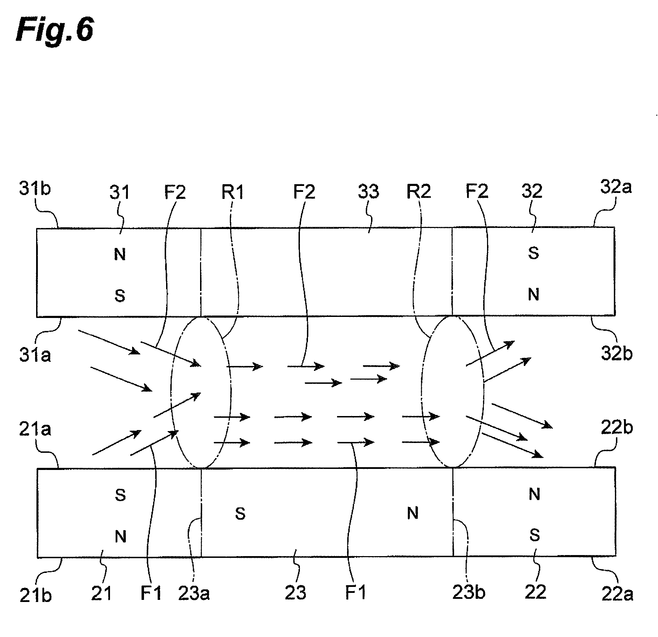

Next, the magnetic field formed by the lower magnetic body 20 and the cap structure 30 will be described with reference to Fig. 6. Fig. 6 is a drawing schematically showing the distribution of the magnetic field in a cross section indicated by the line II-II in Fig. 1 (i.e., the same cross section as Fig. 2).

The magnetic field F1 by the lower magnetic body 20 is formed as oriented from the magnetic pole 21a of the first polarity of the first magnetic portion 21 toward the magnetic pole 22b of the second polarity of the second magnetic portion 22. The magnetic field F2 by the cap structure 30 is formed as oriented from the magnetic pole 31a of the first polarity of the first region 31 toward the magnetic pole 32b of the second polarity of the second region 32. As shown in Fig. 6, the magnetic fields F1, F2 are formed approximately along the surfaces of the lower magnetic body 20 and the cap structure 30, at positions between the third magnetic portion 23 and the third region 33. An ellipse R1 and an ellipse R2 schematically show regions where the first coil 17 and the second coil 18 are located. The magnetic field formed by the first magnetic portion 21, the second magnetic portion 22, the first region 31, and the second region 32 is concentrated at positions indicated by the ellipse R1 and the ellipse R2. This enhances the force exerted on the first coil 17 and the second coil 18 with supply of the electric current to the first coil 17 and the second coil 18, at the positions indicated by the ellipse R1 and the ellipse R2.

An example of an assembly process of the mirror device 1 configured as described above will be described. First, the mirror structure 10 and the lower magnetic body 20 are fixed in the opening portion 41 of the housing 40. Next, the first region 31 and the second region 32 in the cap structure 30 are preliminarily magnetized. Then, the cap structure 30 is bonded to the housing 40 so as to cover the opening portion 41. The mirror device 1 is obtained through the above assembly process.

An operation of the mirror device 1 is as described below. When an electric current according to a desired angle of the mirror 16 is supplied to the coil 17, a force according to the supplied electric current is generated in the first coil 17. The first movable portion 12 rotates around the straight line A1 (cf. Fig. 4) to an angle at which the force generated in the coil 17 and the resilience of the first beams 14 are in balance.

Similarly, when an electric current according to a desired angle of the mirror 16 is supplied to the second coil 18, a force according to the supplied electric current is generated in the second coil 18. The second movable portion 13 rotates around the straight line A2 (cf. Fig. 4) to an angle at which the force generated in the second coil 18 and the resilience of the second beams 15 are in balance.

In the mirror device 1, light travels from a side in the positive direction of the Z-axis through the through hole 34 to be incident on the mirror 16 and the light being incident on the mirror 16 is reflected toward the side in the positive direction of the Z-axis to travel again through the through hole 34. The traveling direction of the reflected light varies depending upon the angles of the mirror 16. The angles of the mirror 16 can be controlled by rotating the first movable portion 12 and the second movable portion 13 with variation in magnitudes of the electric currents supplied to the first coil 17 and to the second coil 18, as described above. Therefore, the traveling direction of the light reflected by the mirror device 1 can be controlled by controlling the electric currents supplied to the first coil 17 and to the second coil 18.

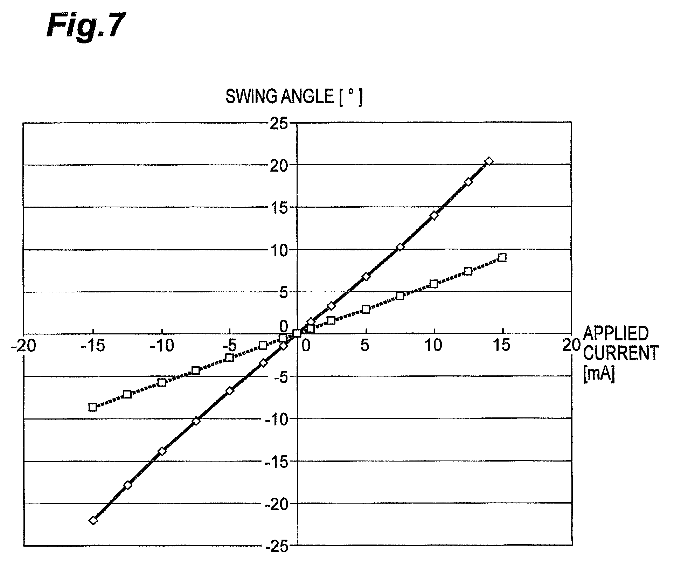

Fig. 7 is a drawing showing a comparison between swing angles of the mirror 16 in the mirror device 1 of the present embodiment and swing angles of a mirror in a mirror device of a comparative example. The horizontal axis of Fig. 7 represents the applied currents (unit: mA) applied to the first coil 17 and the second coil 18. The vertical axis of Fig. 7 represents the swing angles (unit: °). The solid curve in Fig. 7 indicates the swing angles of the mirror 16 in the mirror device 1 of the present embodiment. The dashed curve in Fig. 7 indicates the swing angles of the mirror in the mirror device of the comparative example. The mirror device of the comparative example is different in the absence of the cap structure 30 from the mirror device 1 of the present embodiment and has the configuration equivalent to the mirror device 1 of the present embodiment, in the other respects.

At the applied current of 10 mA, as shown in Fig. 7, the swing angle of the mirror device 1 of the present embodiment is about 14°, whereas the swing angle of the mirror device of the comparative example is about 6°. In this manner, the mirror device 1 of the present embodiment achieves the swing angle not less than twice that by the mirror device of the comparative example.

The mirror device 1 of the present embodiment is configured so as to oppose the magnetic pole 21a of the first polarity of the first magnetic portion 21 to the magnetic pole 31a of the first polarity of the first region 31 of the cap structure 30 and so as to oppose the magnetic pole 22b of the second polarity of the second magnetic portion 22 to the magnetic pole 32b of the second polarity of the second region 32 of the cap structure 30. For this reason, the first magnetic portion 21, second magnetic portion 22, and, the first region 31 and second region 32 of the cap structure 30 form the strong magnetic fields F1, F2 in the vicinity of the first coil 17 and second coil 18. By adjusting the size of the unmagnetized third region 33 located between the first region 31 and the second region 32, the magnetic fields F1, F2 formed by the first region 31 and the second region 32 can be concentrated in the vicinity of the first coil 17 and second coil 18. Furthermore, the magnetic fields F1, F2 are confined in the vicinity of the first coil 17 and the second coil 18 by the cap structure 30 including the third region 33. This further enhances the magnetic fields in the vicinity of the first coil 17 and second coil 18.

Here, the first region 31 and second region 32 forming the magnetic fields F1, F2 in the vicinity of the first coil 17 and second coil 18 are integrally formed as the cap structure 30. For this reason, it becomes easy to highly accurately position the first region 31 and second region 32 relative to the first coil 17 and second coil 18. Therefore, the mirror device 1 can positively concentrate the magnetic fields F1, F2 in the vicinity of the first coil 17 and second coil 18.

Furthermore, the mirror device 1 further includes the housing 40 including the opening portion 41 and housing the mirror structure 10, the first magnetic portion 21, and the second magnetic portion 22. The cap structure 30 is disposed to cover the opening portion 41. For this reason, the first magnetic portion 21 and second magnetic portion 22 are positioned relative to the mirror structure 10 when housed in the housing 40. At the same time, since the opening portion 41 of the housing 40 is covered by the cap structure 30, the magnetic fields F1, F2 are confined in the vicinity of the first coil 17 and second coil 18. For this reason, the magnetic fields F1, F2 formed by the first magnetic portion 21 and second magnetic portion 22 can be more positively concentrated in the vicinity of the first coil 17 and second coil 18.

In the third region 33, the through hole 34 is formed at the position corresponding to the mirror 16 and the through hole 34 is defined by the tapered inner surface 34a with its diameter increasing from the same side as the surface 30a of the cap structure 30 opposed to the mirror structure 10, toward the back surface 30b side. For enhancing the magnetic fields F1, F2 in the vicinity of the first coil 17 and second coil 18 of the mirror structure 10, it is necessary to increase the thickness of the cap structure 30 and locate the cap structure 30 at the position close to the mirror structure 10. However, the through hole 34 is defined by the tapered inner surface 34a with the diameter increasing from the surface 30a side to the back surface 30b side of the cap structure 30, as described above. This makes the light being incident through the through hole 34 onto the mirror 16 and the light passing through the through hole 34 after reflected by the mirror 16, less likely to interfere with the peripheral portion of the through hole 34. For this reason, the angles of input/output of the light to or from the mirror 16 can be made larger.

The mirror device further includes the third magnetic portion 23 disposed between the first magnetic portion 21 and the second magnetic portion 22, and the first magnetic portion 21, third magnetic portion 23, and second magnetic portion 22 constitute the Halbach array. For this reason, the magnetic fields F1, F2 formed in the vicinity of the first coil 17 and the second coil 18 can be more enhanced by the first magnetic portion 21, third magnetic portion 23, and second magnetic portion 22 constituting the Halbach array.

The cap structure 30 comprises the single member and includes the first region 31 and the second region 32 obtained by magnetizing the respective corresponding regions in the single member. For this reason, when the single member including the first region 31 and the second region 32 is positioned relative to the mirror structure 10, both of the first region 31 and second region 32 are positively positioned at the desired positions relative to the mirror structure 10. For this reason, the magnetic fields F1, F2 can be more positively concentrated in the vicinity of the first coil 17 and second coil 18.

The first magnetic portion 21 and the second magnetic portion 22 are configured by magnetizing the respective corresponding regions in the lower magnetic body 20 being the single member. For this reason, when the lower magnetic body 20 of the single member constituting the first magnetic portion 21 and the second magnetic portion 22 is positioned relative to the mirror structure 10, both of the first magnetic portion 21 and second magnetic portion 22 are positively positioned at the desired positions relative to the mirror structure 10. For this reason, the magnetic fields F1, F2 can be more positively concentrated in the vicinity of the first coil 17 and second coil 18.

The first coil 17 and second coil 18 have the substantially rectangular shape and the first magnetic portion 21 and second magnetic portion 22 are arranged in the direction intersecting with the extending directions of the respective sides of the first coil 17 and the second coil 18 (i.e., the X-axis direction and the Y-axis direction). For this reason, the direction of the magnetic field formed by the first magnetic portion 21 and the second magnetic portion 22 is aligned with the direction intersecting with the extending directions of the respective sides of the first coil 17 and the second coil 18. Therefore, when the electric current is supplied to the first coil 17 and the second coil 18, the force acts on all the sides of the first coil 17 and the second coil 18. For this reason, the mirror 16 can be efficiently swung.

In the present embodiment, the first magnetic portion 21 and second magnetic portion 22 disposed below the mirror structure are disposed to generate the magnetic field in the direction intersecting with both of the X-axis and the Y-axis. For this reason, when the magnetic body is disposed above the mirror structure 10, it needs to be arranged in the direction intersecting with both of the X-axis and Y-axis, along the direction of the magnetic field generated by the first magnetic portion 21 and the second magnetic portion 22. In this case, the positioning of the magnetic body disposed above the mirror structure 10 is much more difficult than in the case where the magnetic body is disposed in parallel to the X-axis or the Y-axis. In the present embodiment, however, the cap structure 30 comprises the single member and the first region 31 and second region 32 are formed by magnetizing the respective corresponding regions in the cap structure 30. For this reason, the alignment of the first region 31 and second region 32 can also be accurately adjusted by the magnetization.

The embodiment of the present invention has been described above, but it should be noted that the present invention does not always have to be limited solely to the above-described embodiment but can also be modified in many ways without departing from the spirit and scope of the invention.

The above embodiment was configured so that the lower magnetic body 20 was housed in the housing 40, but the lower magnetic body 20 and housing 40 may be integrated.

In the above embodiment, the through hole 34 was described as one defined by the tapered inner surface 34a. However, the through hole 34 may be one defined by the inner surface normal to the surface 30a of the cap structure 30 opposed to the mirror structure 10, or, by the inner surface parallel to the Z-axis.

In the above embodiment, the lower magnetic body 20 includes the third magnetic portion 23. However, a portion equivalent to the third magnetic portion 23 in the lower magnetic body 20 may be an unmagnetized one.

In the above embodiment, the cap structure 30 is the single member including the first region 31, second region 32, and third region 33. However, the cap structure may be configured so that a member corresponding to the first region 31, a member corresponding to the second region 32, and a member corresponding to the third region 33 are prepared as separate members and so that these members are combined to constitute the cap structure.

In the above embodiment the first magnetic portion 21, second magnetic portion 22, and third magnetic portion 23 were those formed by magnetizing the respective corresponding regions in the single member, but the first magnetic portion 21, second magnetic portion 22, and third magnetic portion 23 may be configured as respective separate members.

For enhancing the magnetic fields F1, F2 in the vicinity of the first coil 17 and second coil 18, a magnetic body may also be disposed beside the mirror structure 10, in addition to the cap structure 30 above the mirror structure 10 and the lower magnetic body 20 below the mirror structure 10. Specifically, for example, the magnetic body may be disposed on the side wall of the housing 40. In this case, the magnetic body may be bonded to the side wall; or, a groove may be formed in the side wall of the housing 40 and the magnetic body may be embedded in this groove.

In the above embodiment, as shown in Fig. 5, the second coil 18 is disposed around the mirror 16. However, the second coil 18 may be disposed immediately below the mirror 16. In other words, the second coil 18 may be located on the same side as the first magnetic portion 21 and the second magnetic portion 22 with respect to the mirror 16 and disposed at a position where it overlaps the mirror 16 when viewed from the direction normal to the mirror 16 (i.e., the Z-axis direction).

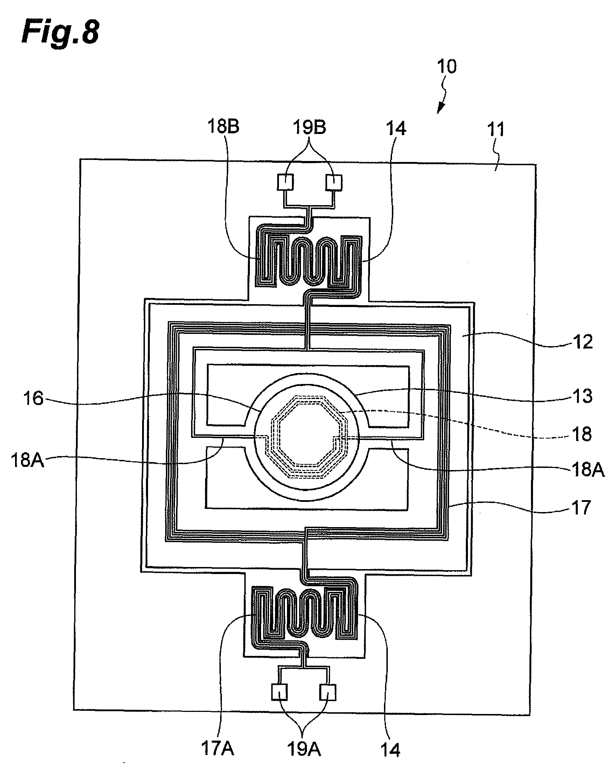

A modification example wherein the second coil 18 is disposed immediately below the mirror 16 is shown in Fig. 8. In the mirror structure 10 shown in Fig. 8, the second movable portion 13 is of a circular shape slightly larger than the mirror 16. The second coil 18 is of a spiral shape of a substantially regular octagon and is disposed immediately below the mirror 16.

The same operational effect as in the aforementioned embodiment is also achieved in the case using the mirror structure 10 of the modification example shown in Fig. 8, instead of the mirror structure 10 shown in Fig. 5. In the mirror structure 10 shown in Fig. 8, the second coil 18 is disposed on the same side as the first magnetic portion 21 and second magnetic portion 22 with respect to the mirror 16 (on the negative side of the Z-axis direction) and disposed to overlap the mirror 16 when viewed from the direction normal to the mirror 16 (the Z-axis direction). When the second coil 18 is disposed in this manner, it is necessary to locate the first magnetic portion 21 and the second magnetic portion 22 forming the magnetic field, nearer to each other, in order to form the magnetic field at the position close to the center of the mirror structure 10, where the second coil 18 is disposed. In conjunction with the arrangement of locating the first magnetic portion 21 and the second magnetic portion 22 nearer to each other, it is also necessary to locate the first region 31 and the second region 32 closer to each other. When the first region 31 and the second region 32 are configured as separate magnetic bodies and when the first region 31 and the second region 32 are located close to each other, it is difficult to assemble the mirror device 1 while adequately adjusting the distance between the first region 31 and the second region 32. In the present modification example, however, the first region 31 and the second region 32 are disposed as the regions of the cap structure 30, whereby it is easier to accurately adjust the distance between the first region 31 and the second region 32 during the assembly of the mirror device 1.

### Industrial Applicability

The present invention is applicable to a mirror devices.

### Reference Signs List

1 mirror device; 10 mirror structure; 10a surface where mirror 16 of mirror structure 10 is disposed; 10b back side with respect to surface 10a; 12 first movable portion (movable portion); 13 second movable portion (movable portion); 16 mirror; 17 first coil (coil); 18 second coil (coil); 21 first magnetic portion; 21 a magnetic pole of first polarity of first magnetic portion 21; 22 second magnetic portion; 22b magnetic pole of second polarity of second magnetic portion 22; 23 third magnetic portion; 30 cap structure; 31 first region; 31a magnetic pole of first polarity of first region 31; 32 second region; 32b magnetic pole of second polarity of second magnetic region 32; 33 third region; 34 through hole; 34a inner surface of through hole 34; 40 housing; 41 opening portion.

## Claims

1. A mirror device comprising:
a mirror structure including a support portion, a movable portion coupled to the support portion so as to be swingable, and, a mirror and a coil disposed on the movable portion;
a first magnetic portion having a magnetic pole of a first polarity and disposed on a back side of the mirror structure with respect to a surface where the mirror thereof is disposed, so that the magnetic pole of the first polarity is opposed to the mirror structure;
a second magnetic portion having a magnetic pole of a second polarity different from the first polarity and disposed on the back side of the mirror structure so that the magnetic pole of the second polarity is opposed to the mirror structure; and
a cap structure disposed on a same side as the surface where the mirror of the mirror structure is disposed,
wherein the cap structure includes:
a first region having a magnetic pole of the first polarity located to be opposed to the magnetic pole of the first polarity of the first magnetic portion;
a second region having a magnetic pole of the second polarity located to be opposed to the magnetic pole of the second polarity of the second magnetic portion; and
an unmagnetized third region located between the first region and the second region.

2. The mirror device according to claim 1, further comprising:
a housing including an opening portion and housing the mirror structure, the first magnetic portion, and the second magnetic portion,
wherein the cap structure is disposed to cover the opening portion.

3. The mirror device according to claim 1 or 2,
wherein a through hole is formed at a position corresponding to the mirror in the third region and the through hole is defined by a tapered inner surface with its diameter increasing from a same side as a surface of the cap structure opposed to the mirror structure, to a back side of the cap structure.

4. The mirror device according to any one of claims 1 to 3, further comprising:
a third magnetic portion disposed between the first magnetic portion and the second magnetic portion,
wherein the first magnetic portion, the third magnetic portion, and the second magnetic portion constitute a Halbach array.

5. The mirror device according to any one of claims 1 to 4, wherein the cap structure comprises a single member and includes the first region and the second region obtained by magnetizing respective corresponding regions in the single member.

6. The mirror device according to any one of claims 1 to 5, wherein the first magnetic portion and the second magnetic portion are configured by magnetizing respective corresponding regions in a single member.

7. The mirror device according to any one of claims 1 to 6, wherein the coil has a substantially rectangular shape, and
wherein the first magnetic portion and the second magnetic portion are disposed in a direction intersecting with extending directions of respective sides of the coil.

8. The mirror device according to any one of claims 1 to 7,
wherein the coil is disposed on a same side as the first magnetic portion and the second magnetic portion with respect to the mirror and disposed to overlap the mirror when viewed from a direction normal to the mirror.
